Europäisches Patentamt

European Patent Office

Office européen des brevets

Veröffentlichungsnummer: **0 284 957**

**A2**

# EUROPÄISCHE PATENTANMELDUNG

Anmeldenummer: **88104550.4**

Anmeldetag: **22.03.88**

Int. Cl.⁴: **H03M 1/18**

Priorität: **28.03.87 DE 3710291**

Veröffentlichungstag der Anmeldung:
**05.10.88 Patentblatt 88/40**

Benannte Vertragsstaaten:
**AT BE CH DE ES FR GB GR IT LI LU NL SE**

Anmelder: **Deutsche Thomson-Brandt GmbH
Postfach 2060
D-7730 Villingen-Schwenningen(DE)**

Erfinder: **Ruffray, Jean-Claude
Hans Thoma Strasse 6
D-7734 Brigachtal(DE)**

Vertreter: **Körner, Peter, Dipl.-Ing.
Deutsche Thomson-Brandt GmbH Patent-
und Lizenzabteilung Göttinger Chaussee 76
D-3000 Hannover 91(DE)**

**Schaltung zur Analog/Digital Wandlung von Signalen unterschiedlicher Pegel.**

1. Schaltungsanordnung zur Analog/Digital-Wandlung von Signalen unterschiedlicher Pegel.

2.1 Bei einer Schaltung zur Analog/Digital-Wandlung von Signalen unterschiedlicher Pegel ist es bereits bekannt, die Signale über einen Dynamikompressor auf den Analog/Digital-Wandler zu geben und den Pegel so zu steuern, daß der Aussteuerbereich des Analog/Digital-Wandlers bei etwa allen Pegeln ausgenutzt wird.

2.2 Es werden zu Beginn eines Angleichungsvorganges Aussteuerbereichsüberschreitungen gezählt und über einen Digital/Analog-Wandler steuerbare Stromquellen angesteuert, die die Stufenhöhe der Quantisierungsstufen des Flash Converters erweitern. Dies geschieht solange, bis ein stationärer Zustand erreicht ist. Vorzugsweise wird als Analog/Digital-Wandler ein Flash Converter verwendet.

2.3 Die Maßnahme ist bei digitalisierten Videogeräten anwendbar, die Signale unterschiedlicher Signalquellen und damit unterschiedlicher Eingangspegel verarbeiten sollen.

EP 0 284 957 A2

# Schaltung zur Analog/Digital-Wandlung von Signalen unterschiedlicher Pegel

Die Erfindung betrifft eine Schaltung zur Analog/Digital-Wandlung von Signalen unterschiedlicher Pegel nach dem Oberbegriff des Anspruchs 1.

Bei der Anpassung von Signalquellen an einen Analog/Digital-Wandler wird angestrebt, die Quantisierungsfehler möglichst gering zu machen. Ein minimaler Fehler wird erreicht, wenn die maximale Amplitude des Analogsignals gerade unterhalb der Bereichsgrenzen des Analog/Digital-Wandlers liegt.

Es ist bereits bekannt, einem Analog/Digital-Wandler einen Dynamikkompressor vorzuschalten und die Amplitude des Analogsignals so zu steuern, daß die Bereichsgrenze des Analog/Digital-Wandlers gerade eingehalten werden. Diese Lösung erfordert jedoch analogseitig lineare Stellglieder, was besonders bei breitbandigen Signalen einen hohen Aufwand bedeutet.

Der Erfindung liegt die Aufgabe zugrunde, eine Schaltung zur Analog/Digital-Wandlung von Signalen unterschiedlicher Pegel zu schaffen, die ohne analogseitige Änderung des Verstärkungsfaktors jeweils eine optimale Ausnutzung der Aussteuergrenzen des Analog/Digital-Wandlers erlaubt.

Diese Aufgabe wird bei einer Schaltung nach dem Oberbegriff des Anspruchs 1 durch die im kennzeichnenden Teil angegebenen Merkmale gelöst.

Bei der erfindungsgemäßen Schaltung werden die Aussteuergrenzen des Analog/Digital-Wandlers solange verschoben, bis das Analogsignal die Aussteuergrenzen gerade nicht mehr über schreitet. Dies kann auf zweierlei Weise geschehen. Zum einen können die Aussteuergrenzen zunehmend eingeschränkt werden, bis eine erste Bereichsüberschreitung auftritt und anschließend um einige Stufen wieder rückgängig gemacht werden. Zum anderen kommt eine Erweiterung der Aussteuergrenzen in Betracht, die solange vorgenommen wird, bis keine Bereichsüberschreitungen mehr stattfinden. Eine Änderung der Aussteuergrenzen wird dabei zweckmäßig mit jedem Taktimpuls vorgenommen, indem auch eine Signalprobe aus dem Analogsignal gewonnen wird. Sobald keine Bereichsüberschreitung mehr eintreten, können dann die Aussteuergrenzen festgehalten werden.

Der beschriebene Vorgang kann nach vorgegebenen Zeiten überprüft werden, indem die Schaltung in den Ausgangszustand zurückgesetzt wird und die Aussteuergrenzen neu bestimmt werden. Dies wird zweckmäßig stets bei Einschalten einer neuen Signalquelle vorgenommen, oder kann, im Falle von Videosignalen, auch zu einem Zeitpunkt erfolgen, in dem noch keine sichtbaren Signale wiedergegeben werden. Bei der Überwachung von Bereichsüberschreitungen können sowohl positive, ausschließlich negative oder auch positive und negative Bereichsüberschreitungen ausgewertet werden.

Besonders vorteilhaft ist die Ausbildung des Analog/Digital-Wanders als Flash Converter. Durch seine parallele Arbeitsweise ermöglicht dieser Wandlertyp eine extrem schnelle Signalumsetzung, die auch die Verarbeitung breitbandiger Signale ermöglicht.

Weiterbildungen und vorteilhafte Ausführungsformen der Erfindung ergeben sich aus der Ansprüchen, der weiteren Beschreibung und der Zeichnung, die ein Ausführungsbeispiel der Erfindung veranschaulicht.

Es zeigen

Fig. 1 ein Blockschaltbild der erfindungsgemäßen Schaltung,

Fig. 2 eine schematische Darstellung eines als Flash Converter ausgebildeten Analog/Digital-Wandlers, wie er bei der Erfindung besonders geeignet ist,

Fig. 3 eine Darstellung eines Signalverlaufs am Beispiel eines zusammengesetzten Videosignals,

Fig. 4 eine Darstellung eines Signalverlaufs am Beispiel eines Farbdifferenzsignals.

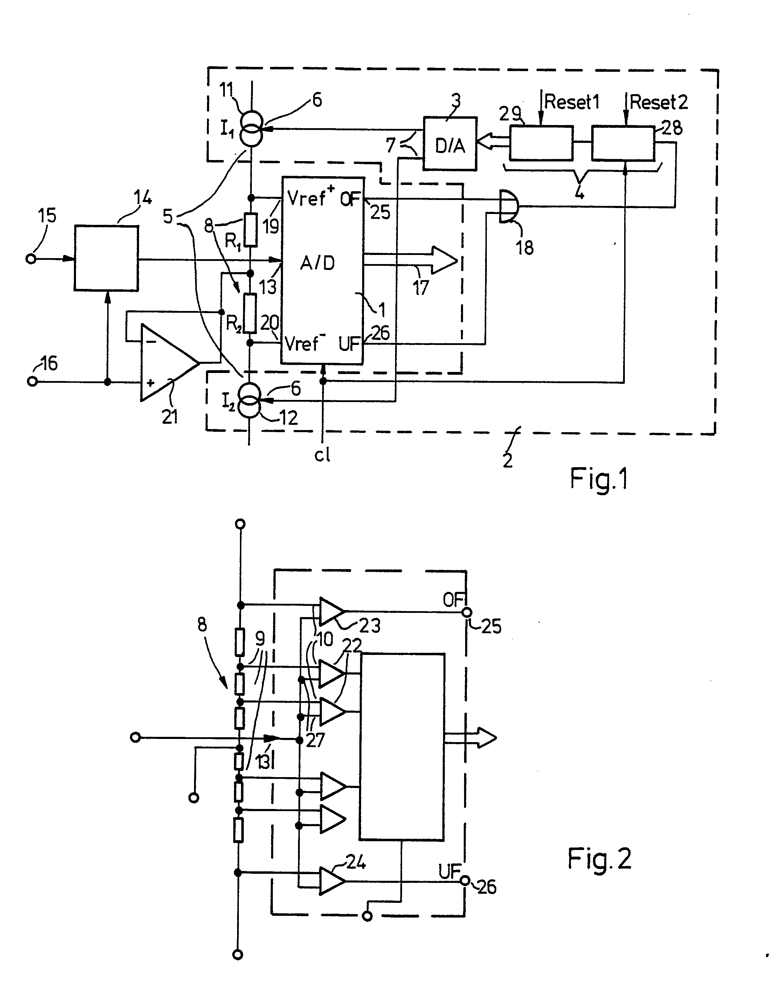

Bei der in Fig. 1 dargestellten Schaltung werden Eingangssignale über eine Eingangsklemme 15 und ein Bezugswert der Eingangssignale über eine Eingangsklemme 16 zugeführt. Digitalisierte Signale sind an einem Ausgang 17 abgreifbar.

Die Schaltung besteht weiter aus einem Analog/Digital-Wandler, der hier als Flash Converter 1 ausgebildet und in Fig. 2 noch näher veranschaulicht ist, sowie einer durch eine gestrichelte Rahmenlinie angedeuteten Steuerschaltung 2. Die Steuerschaltung 2 umfaßt einen Digital/AnalogWandler 3, eine den Digital/Analog-Wandler ansteuernde Zählerordnung 4, eine steuerbare Stromquelleanordnung 5 und ein logisches Verknüpfungsglied 18. Zur Gewinnung von Referenzspannungen an Referenzeingängen 19 und 20 dienen Spannungsteiler 8. Dem Flash Converter 1 ist außerdem eine Klemmschaltung 14 vorgeschaltet, die das Bezugspotential des Flash Converters 1 in Abhängigkeit der Symmetrie des Eingangssignals steuert. Außerdem ist zwischen der Eingangsklemme 16 und einer Bezugsklemme des Spannungsteilers 8 ein Spannungsfolger 21 angeordnet.

Zur Erläuterung der Funktion der in Fig. 1 dargestellten Schaltung wird noch die Arbeitsweise des Flash Converter 1 für sich an Hand der Fig. 2 erläutert. Der Flash Converter 1 umfaßt intern eine Reihe von Komparatoren 22, deren Anzahl gleich der möglichen Quantisierungsstufen ist. Zusätzlich sind noch zwei Komparatoren 23 und 24 vorhanden, die zur Erkennung von Überschreitungen der Aussteuerbereichsgrenzen dienen. Ihre Ausgangssignale sind als Overflow bzw. Underflow bezeichnet und über Ausgänge 25 bzw. 26 herausgeführt.

Die einen Anschlüsse 10 der Komparatoren 22 erhalten über Ausgänge 9 des mehrstufigen Spannungsteilers 8 abgestufte Spannungen, deren Abstufungen den Quantisierungsstufen entsprechen. Die anderen Eingänge 27 sind miteinander verbunden und als Eingang 13 herausgeführt. Gelangt über den Eingang 13 ein Signal zu den anderen Eingängen 27 der Komparatoren 22, so wechselt das Potential am Ausgang der Komparatoren, bei denen die Eingangsspannung am Eingang 13 höher ist als die Referenzspannung an dem betreffenden Ausgang 9 des Spannungsteilers 8. Aus den Ausgangssignalen der Komparatoren 22 wird dann in einem logischen Verknüpfungsnetzwerk ein entsprechendes digitales Datenwort ermittelt und an den Ausgang 17 durchgeschaltet.

Zur weiteren Erläuterung wird nun wieder auf Fig. 1 Bezug genommen. An der Eingangsklemme 15 treten Signale unterschiedlicher Pegel auf, wie sie durch unterschiedliche Signalquellen, die durch Leitungsdämpfungen oder auch durch Aussteuerungsfehler bei der Übertragung und Aufzeichnung nicht exakt aneinander angepaßt sind, ergeben können. Wenn Signale geringer Pegel unverändert beibehalten werden, würde die Digitalisierung sehr grob ausfallen. Ist der Pegel dagegen hoch, würden Signalspitzen einfach abgeschnitten.

Um Signale unterschiedlicher Pegel so verarbeiten zu können, daß diese den zur Verfügung stehenden Aussteuerbereich des Flash Converters 1 gerade nutzen, werden zunächst enge Bereichsgrenzen eingestellt und geprüft, ob das Signal die Aussteuerbereichsgrenzen überschreitet. Die Einstellung enger Bereichsgrenzen geschieht dadurch, daß von den Stromquellen 11 und 12 der Stromquellenanordnung 5 nur ein geringer Strom in den Spannungsteiler 8 eingespeist wird. Die an den Eingängen 19 und 20 anliegende Referenzspannung ist dementsprechend auch klein. Sobald nun das Eingangssignal eine der Aussteuerbereichgrenzen überschreitet, erscheint am Ausgang 25 oder 26 ein Overflow oder Underflow. Das Overflow oder Underflow-Signal gelangt dann über ein logisches Verknüpfungsglied 4, das hier als ODER-Glied ausgebildet ist, auf einen Zähleingang der Zähleranordnung 4. Bei jeder Bereichsüberschreitung wird ein erster Zähler 28 um einen Schritt weitergezählt und das Ergebnis von einem zweiten Zähler 29 übernommen.

Das Ausgangssignal des zweiten Zählers 29 steuert den Digital/Analog-Wandler 3, welcher über seine Ausgänge 7 Steuereingänge 6 der steuerbaren Stromquellen 11 oder 12 beaufschlagt. Diese erhöhen daraufhin den Stromfluß durch den Spannungsteiler 8, so daß die Stufenweite der Quantisierungsstufen des Flash Converters 1 erhöht wird. Dieser Vorgang wiederholt sich anschließend solange, bis ein Gleichgewicht eingestellt ist, das heißt, bis die nachfolgenden Signale gerade nicht mehr die Aussteuerbereichsgrenzen überschreiten.

In regelmäßigen Abständen wird durch Rücksetzen des Zählers 29 über Reset 1 der Vorgang wiederholt, um festzustellen, ob der Pegel nicht inzwischen zurückgegangen ist und eine neue Einstellung zweckmäßig ist. Dieser Zeitpunkt kann bei Videosignalen z.B. der Durchlauf einer Zeile, eines Bildes oder auch die Umschaltung auf eine andere Signalquelle sein. Vorzugsweise wird die Überprüfung bei Signalen durchgeführt, die noch nicht auf dem Bildschirm sichtbar werden.

Der erste Zähler 28 kann auch so ausgebildet sein, daß er zunächst eine Reihe von Aussteuerbereichsüberschreitungen registriert und erst ab einer bestimmten Anzahl von Aussteuerbereichsüberschreitungen diese Informationen an den Zähler 29 weitergibt. Mit dieser Maßnahme kann verhindert werden, daß kurzzeitige Fremdstörungen, die keinen Bezug zum Signalpegel haben, die Einstellung verfälschen. Der Zähler 28 wird zweckmäßig nach einer kürzeren Zeit als der Zähler 29 über Reset 2 zurückgesetzt.

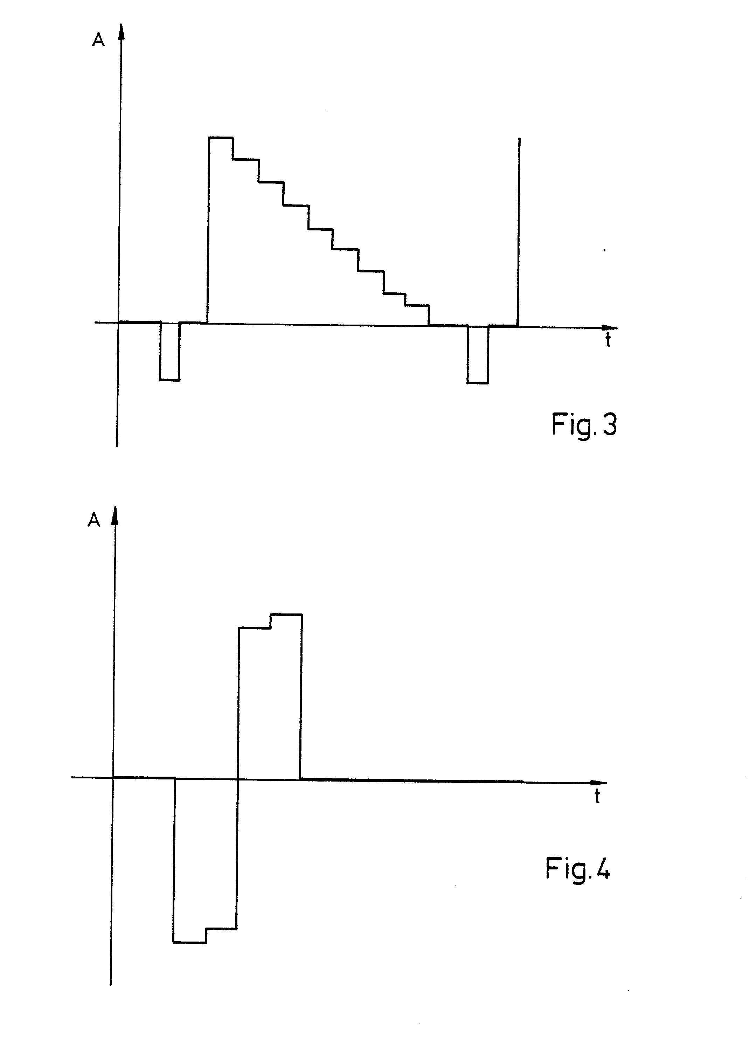

Da beim Videosignal, wie es in Fig. 3 dargestellt ist, Unsymmetrien auftauchen, kann es zweckmäßig sein, den positiven und negativen Bereich gesondert zu behandeln. Dazu dient die Klemmschaltung 14, welche das Bezugspotential des Flashkonverters in Abhängigkeit der Symmetrie des Eingangssignals steuert.

## Ansprüche

1. Schaltung zur Analog/Digital-Wandlung von Signalen unterschiedlicher Pegel mit einem Analog/Digital-Wandler (1) sowie einer Steuerschaltung zur Angleichung der Maximalwerte der Signale und des Aussteuerbereichs des Analog/Digital-Wandlers (1) aneinander, dadurch gekennzeichnet, daß die Steuerschaltung (2) einen die Aussteuerbereichsgrenzen des Analog/Digital-Wandlers (1) in Abhängigkeit von Bereichsüberschreitungen steuernden Digital/Analog-Wandler (3) umfaßt.

2. Schaltung nach Anspruch 1, dadurch gekennzeichnet, daß die Steuerschaltung (2) eine jede positive und/oder negative Bereichsüberschreitung innerhalb einer vorgegebenen Zeitspanne registrierende und den Digital Analog-Wandler (3) mit dem registrierten Wert ansteuernde Zähleranordnung (4) umfaßt.

3. Schaltung nach Anspruch 2, dadurch gekennzeichnet, daß die vorgegebene Zeitspanne zur Registrierung von Be reichsüberschreitungen durch die Zähleranordnung (4) gleich der Zeitspanne ist, die der Analog/Digital-Wandler (1) zur Umwandlung eines Analogwertes in einen Digitalwert benötigt, und eine Taktperiode beträgt.

4. Schaltung nach einem oder mehreren der Ansprüche 1 bis 3, dadurch gekennzeichnet, daß die Steuerschaltung (2) eine steuerbare Stromquelleanordnung (5) umfaßt, deren Steuereingang (6) mit einem Ausgang (7) des Digital/Analog-Wandlers (3) verbunden ist.

5. Schaltung nach Anspruch 4, dadurch gekennzeichnet, daß die Stromquelleanordnung (5) einen mehrstufigen Spannungsteiler (8) speist, an dessen Ausgängen (9) Komparatoreingänge (10) des Analog/Digital-Wandlers (1) angeschlossen sind.

6. Schaltung nach Anspruch 5 oder 6, dadurch gekennzeichnet, daß die Stromquelleanordnung (5) aus einer Stromquelle (11) für positives Potential und einer Stromquelle (12) für negatives Potential besteht.

7. Schaltung nach einem oder mehreren der Ansprüche 1 bis 6, dadurch gekennzeichnet, daß am Eingang (13) des Analog/Digital-Wandlers (1) eine das Bezugspotential des Analog/Digital-Wandlers (1) in Abhängigkeit der Symmetrie des Eingangssignals steuernde Klemmschaltung (14) angeordnet ist.

8. Schaltung nach einem oder mehreren der Ansprüche 1 bis 7, dadurch gekennzeichnet, daß der Analog/Digital-Wandler ein Flash Converter (1) ist.

Fig.1

Fig.2

H87/015-1

Fig. 3

Fig. 4

H87/015-2